# EUROPEAN PATENT APPLICATION

(11) **EP 4 697 921 A1**
(43) Date of publication of application: **18.02.2026**
(21) Application number: 25191138.4
(22) Date of filing: 22.07.2025
(51) Int. Cl.: H10P 72/00, H10P 72/76

(54) **WAFER TRANSFER DEVICE**

(30) Priority: 02.08.2024 TW 113128914
(71) Applicant: Machsync Co., Ltd., Taichung City, 428 (TW)
(72) Inventor: CHEN, JUI-TENG, 404 Taichung City (TW)
(74) Representative: Cabinet Chaillot

(57) **Abstract**

A wafer transfer device for carrying a wafer includes a body, a housing and a displacement sensor. The body has a handle portion and a carrying potion connected to each other, and the carrying portion is used to carry the wafer; the housing has a receiving space, the handle portion is arranged in the receiving space, and the housing is used to connect to an external tool; the displacement sensor is arranged in the housing, and the displacement sensor is used to sense the displacement of the wafer carried by the carrying portion.

## Description

### BACKGROUND OF THE INVENTION

### Technical Field

The present invention relates generally to a wafer transfer device, and more particularly to a wafer transfer device having a displacement sensor.

### Description of Related Art

It is known that in the field of semiconductor industry, a wafer transfer device such as a robotic arm is used to perform wafer transfer operations to achieve more precise transfer movements. However, although the wafer transfer device is controlled by a computer, when the wafer transfer device is subjected to external force collision or other interference, the wafer transfer device will still produce abnormal vibrations or cause the position of the wafer to shift, thereby affecting the accuracy of wafer transfer.

As mentioned above, in order to improve the accuracy of wafer handling, a displacement sensor is generally installed on the robot arm to instantly sense the movement of the wafer on the wafer transfer device. However, when the displacement sensor needs to be inspected or maintained, the disassembly and assembly steps are too complicated and cumbersome, and the maintenance personnel need to spend a lot of time on the inspection or maintenance, which in turn affects the production capacity and efficiency. Therefore, how to provide a wafer transfer device that is convenient for maintenance personnel to perform inspections or maintenance is an urgent problem to be solved.

### BRIEF SUMMARY OF THE INVENTION

In view of the above, the primary objective of the present invention is to provide a wafer transfer device that can facilitate maintenance personnel to perform inspections or maintenance and repairs.

The present invention provides a wafer transfer device, wherein the wafer transfer device is used to carry a wafer, which includes: a body, wherein the body has a handle portion and a carrying portion connected to each other, the carrying portion is used to carry the wafer; a housing, wherein the housing has a receiving space, the handle portion is arranged in the receiving space, the housing is used to connect an external tool; and a displacement sensor, wherein the displacement sensor is arranged in the housing, the displacement sensor is used to sense the displacement of the wafer carried by the carrying portion.

The effect of the present invention is that, by disposing the displacement sensor in the housing, when the displacement sensor needs to be inspected or maintained, maintenance personnel only need to disassemble the housing to quickly perform inspection or maintenance, thereby improving production capacity and efficiency.

### BRIEF DESCRIPTION OF THE SEVERAL VIEWS OF THE DRAWINGS

The present invention will be best understood by referring to the following detailed description of some illustrative embodiments in conjunction with the accompanying drawings, in which
FIG. 1 is a perspective view of a wafer transfer device according to an embodiment of the present invention;
FIG. 2 is a schematic diagram of a partial decomposition of the components of the wafer transfer device according to the embodiment of the present invention;
FIG. 3 is a schematic diagram of a decomposition of the wafer transfer device according to the embodiment of the present invention;
FIG. 4 is a top view of the wafer transfer device of the embodiment with the upper housing removed;
FIG. 5 is a block diagram of the displacement sensor and circuit board assembly of the embodiment of the present invention;

### DETAILED DESCRIPTION OF THE INVENTION

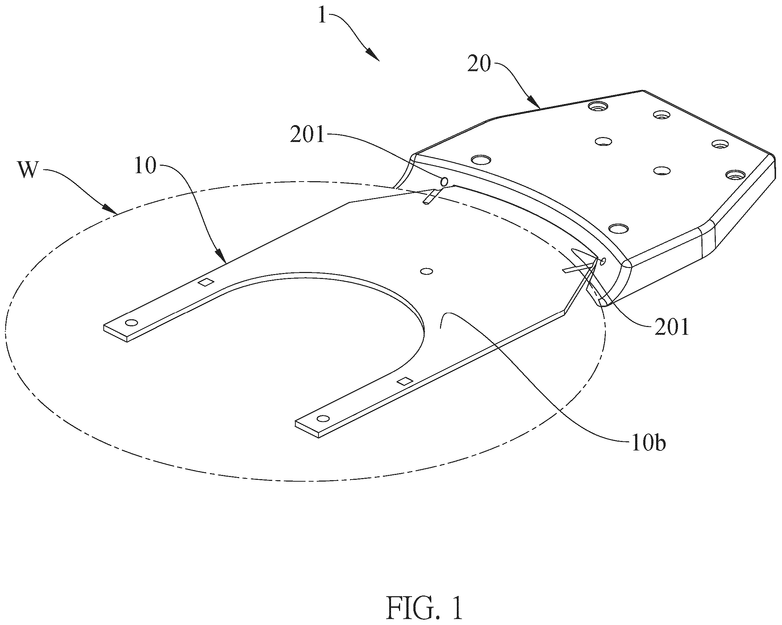

A wafer transfer device 1 according to an embodiment of the present invention is illustrated in FIG. 1 to FIG. 4.

The wafer transfer device 1 is used to carry a wafer W. The wafer transfer device 1 includes a body 10, a housing 20 and a displacement sensor 30. The body 10 has a handle portion 10a and a carrying portion 10b connected to each other, and the carrying portion 10b is used to carry the wafer W; the housing 20 has a receiving space, the handle portion 10a is arranged in the receiving space, and the housing 20 is used to connect an external tool, and the external tool can be a robotic arm; the displacement sensor 30 is arranged in the housing 20, and the displacement sensor 30 is used to sense the displacement of the wafer W carried by the carrying part 10b. In this embodiment, the displacement sensor 30 is explained by taking an electromagnetic displacement sensor as an example. In other embodiments, the displacement sensor can also be a sensor such as an eddy current displacement sensor, a capacitive displacement sensor, a laser displacement sensor or an ultrasonic displacement sensor.

In the present embodiment, the housing 20 is made of a material including carbon fiber. In the present embodiment, the housing 20 is made of a composite material of nylon and carbon fiber. By adopting a light and high-strength carbon fiber material, the protectiveness of the housing 20 can be effectively improved and the weight of the robot arm can be reduced. In other embodiments, the housing 20 can also be made of other light and strong materials, and is not limited to carbon fiber materials.

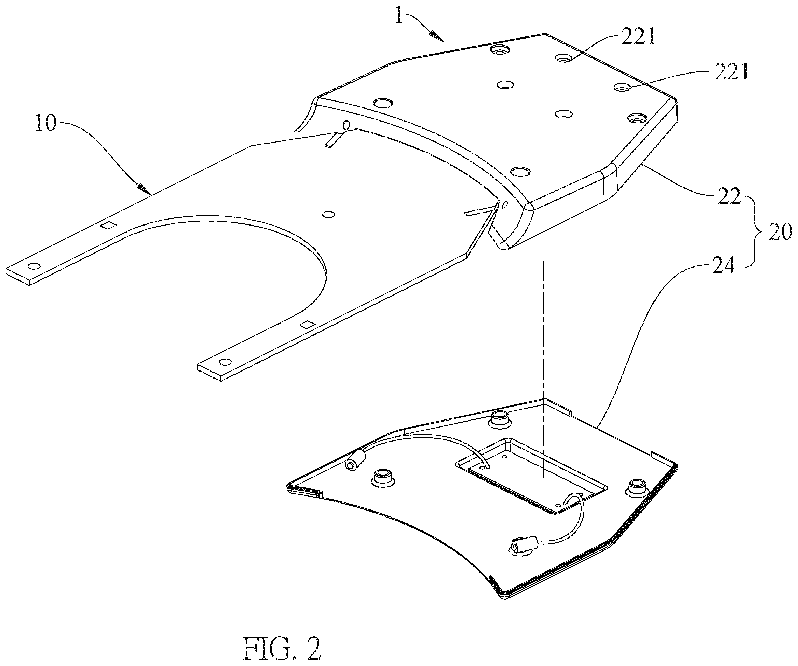

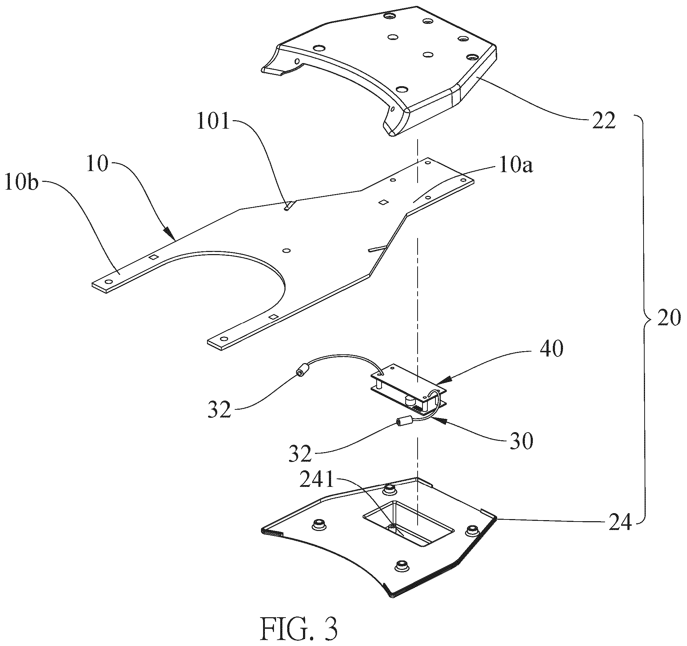

As shown in FIG. 2 and FIG. 3, the housing 20 includes an upper housing 22 and a lower housing 24. The upper housing 22 and the lower housing 24 are detachably connected in a snap-fit or screw-fit manner and are jointly arranged to form the receiving space. The handle portion 10a of the body 10 is disposed in the receiving space, wherein the upper housing 22 has a connection portion for connecting an external tool. In this embodiment, the connection portion is a plurality of connecting holes 221, through the plurality of connecting holes 221 the upper housing 22 can be connected to the robot arm, and the movement of the wafer transfer device 1 can be controlled by the robot arm; in addition, when the displacement sensor 30 needs to be inspected or maintained, as shown in FIG. 2 , the maintenance personnel only need to remove the lower housing 24 from the upper housing 22 to quickly perform inspection or maintenance, thereby improving production capacity and efficiency.

As shown in FIG. 2, the wafer transfer device 1 includes a circuit board assembly 40, and the circuit board assembly 40 is electrically connected to the displacement sensor 30, wherein the lower housing 24 has a mounting portion on one side facing the receiving space, and the mounting portion is a groove 241 for accommodating the circuit board assembly 40, thereby, the circuit board assembly 40 can be stably disposed in the groove 241, when the displacement sensor 30 needs to be inspected or maintained, the maintenance personnel only need to remove the lower housing 24 from the upper housing 22, and the inspection or maintenance can be quickly carried out, thereby improving the production capacity and efficiency; in this embodiment, the mounting portion is explained by taking the groove as an example, in practice, the mounting portion can also be other structures that can install the circuit board assembly, and is not limited to the groove.

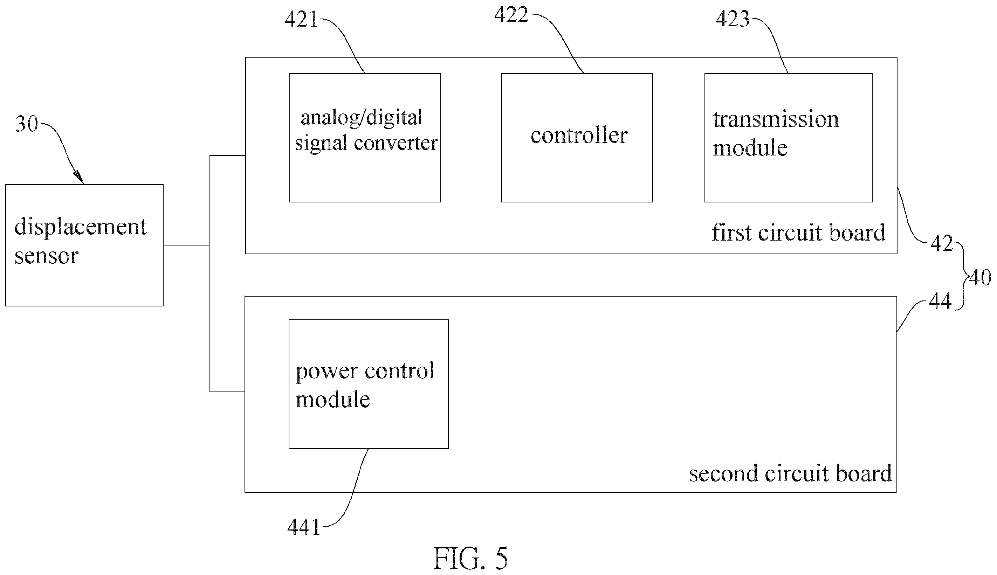

As shown in FIG. 5, the circuit board assembly 40 includes a first circuit board 42 and a second circuit board 44. The first circuit board 42 and the second circuit board 44 are electrically connected to the displacement sensor 30 respectively. The first circuit board 42 receives a sensing signal output by the displacement sensor 30. Further, the first circuit board 42 is provided with an analog/digital signal converter 421, a controller 422 and a transmission module 423. The controller 422 may be, for example, a microcontroller, and the transmission module 423 may be, for example, a wired transmission module or a wireless transmission module. In this embodiment, a wireless transmission module is used as an example. The second circuit board 44 is provided with a power control module 441, which is used to provide operating power for the displacement sensor 30; the displacement sensor 30 is electrically connected to the analog/digital signal converter 421, wherein the controller 422 is electrically connected to the analog/digital signal converter 421 and the transmission module 423, and the controller 422 obtains the sensing signal of the displacement sensor 30 through the analog/digital signal converter 421, and transmits the sensing signal of the displacement sensor 30 to an external electronic device through the transmission module 423, thereby, an operator can receive the sensing signal of the displacement sensor 30 in real time through the external electronic device and effectively monitor and analyze it.

Further, in this embodiment, the upper housing 22 has the connection portion for connecting to the external tool and the lower housing 24 has the mounting portion. In other embodiments, the lower housing may have the connection portion and the upper housing may have the mounting portion. The purpose of providing the connection portion for connecting to external tool and the mounting portion for mounting the circuit board assembly 40 can also be achieved.

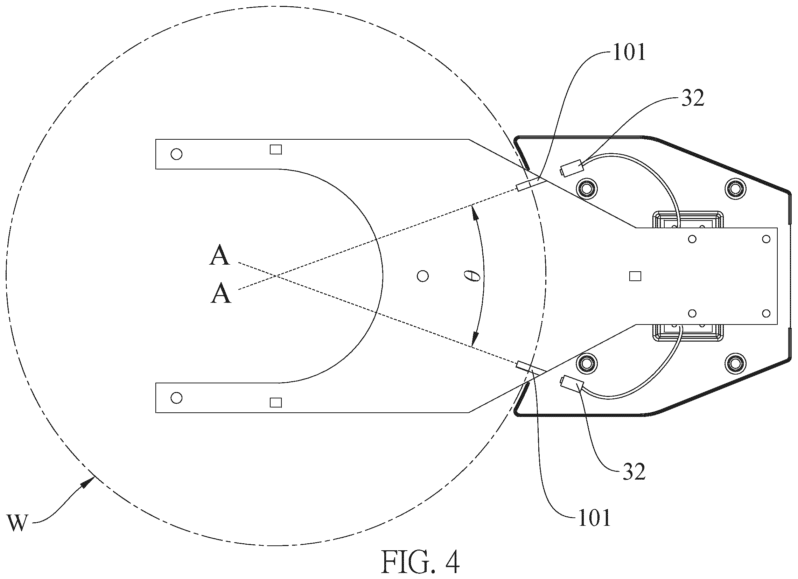

As shown in FIG. 1, the housing 20 has two detection holes 201 on a side facing the carrying portion 10b of the body 10. The two detection holes 201 communicate with the external space and the accommodating space. The displacement sensor 30 has two detection heads 32 respectively disposed at positions adjacent to the two detection holes 201. As shown in FIG. 4, the two detection heads 32 respectively have a signal output axis A. The signal output axis A of the two detection heads 32 passes through the two detection holes 201. As shown in Figure 4, an angle θ of the signal output axis A of the two detection heads 32 is between 40 and 45 degrees. When the wafer transfer device 1 carries the wafer W, the signal output axes A of the two detection heads 32 intersect at the center of mass of the wafer W. It should be noted that the body 10 has two guide grooves 101, each of the guide grooves is formed by being concave from the surface of the main body 10, and each of the guide grooves 101 is extended along the signal output axis A. The signal output axes A of the two detection heads 32 pass through the two guide grooves 101 accordingly, wherein the two guide grooves 101 are semi-arc guide grooves 101; thereby, the signals of the two detection heads 32 can be output from the two detection holes 201 respectively and sent along the two guide grooves 101 to the wafer W to detect the position of the wafer W.

In summary, the present invention disposes the displacement sensor 30 in the housing 20. When the displacement sensor 30 needs to be inspected or maintained, maintenance personnel only need to disassemble the housing 20 to quickly perform the inspection or maintenance, thereby improving production capacity and efficiency.

It must be pointed out that the embodiments described above are only some preferred embodiments of the present invention. All equivalent structures and methods which employ the concepts disclosed in this specification and the appended claims should fall within the scope of the present invention.

## Claims

1. A wafer transfer device, wherein the wafer transfer device is used to carry a wafer, comprising:
a body, wherein the body has a handle portion and a carrying portion connected to each other, the carrying portion is used to carry the wafer;
a housing, wherein the housing has a receiving space, the handle portion is arranged in the receiving space, the housing is used to connect an external tool; and
a displacement sensor, wherein the displacement sensor is arranged in the housing, the displacement sensor is used to sense the displacement of the wafer carried by the carrying portion.

2. The wafer transfer device as claimed in claim 1, wherein the housing includes an upper housing and a lower housing, the upper housing and the lower housing are detachably combined, and the upper housing and the lower housing are jointly enclosing the receiving space, the handle portion of the body is disposed in the receiving space.

3. The wafer transfer device as claimed in claim 2, wherein one of the upper housing or the lower housing has a connection portion for connecting the external tool.

4. The wafer transfer device as claimed in claim 3, further comprises a circuit board assembly, wherein the other of the upper housing or the lower housing has a mounting portion on one side facing the receiving space for accommodating the circuit board assembly, and the circuit board assembly is electrically connected to the displacement sensor.

5. The wafer transfer device as claimed in claim 1, wherein the housing is made of a material including carbon fiber.

6. The wafer transfer device as claimed in claim 1, wherein the housing has two detection holes on a side facing the carrying portion of the body, and the two detection holes are connected to the external space and the receiving space; wherein the displacement sensor has two detection heads respectively arranged at positions adjacent to the two detection holes; wherein the two detection heads respectively have a signal output axis, and the signal output axis of each detection head passes through each detection hole.

7. The wafer transfer device as claimed in claim 6, wherein an angle between the signal output axes of the two detector heads is between 40 and 45 degrees.

8. The wafer transfer device as claimed in claim 6, wherein the body has two guide grooves, each of the guide grooves is formed by being concave from the surface of the body, and the signal output axes of the two detection heads pass through the two guide grooves correspondingly.

9. The wafer transfer device as claimed in claim 8, wherein the two guide grooves are semi-arc guide grooves.

10. The wafer transfer device as claimed in claim 1, further includes a circuit board assembly disposed in the receiving space of the housing, the circuit board assembly is electrically connected to the displacement sensor.
